# EUROPEAN PATENT SPECIFICATION

(11) **EP 2 175 497 B1**
(45) Date of publication and mention of the grant of the patent: **20.11.2019**
(21) Application number: 09162426.2
(22) Date of filing: 10.06.2009
(51) Int. Cl.: H01L 31/107, H01L 31/0312, H01L 31/0352, H01L 31/0224, H01L 27/144

(54) **AVALANCHE PHOTODIODE FOR ULTRAVIOLET PHOTON DETECTION**
LAWINEN-FOTODIODE ZUR DETEKTION VON PHOTONEN IM ULTRAVIOLETTEN BEREICH
PHOTODIODE À AVALANCHE POUR LA DÉTECTION DES PHOTONS DE RAYONNEMENT ULTRAVIOLET

(30) Priority: 12.08.2008 SE 0801780
(43) Date of publication of application: 14.04.2010
(73) Proprietor: Ascatron AB, 164 40 Kista (SE)
(72) Inventor: BAKOWSKI, Mietek, 472 92 Stillingsön (SE)
(74) Representative: Ström & Gulliksson AB

(56) References cited:
- CN-Y- 201 000 897
- GB-A- 2 206 998
- JP-A- 2003 303 956
- US-A- 5 977 605
- US-A1- 2003 224 612
- US-B2- 6 838 741
- XIN X ET AL: "Demonstration of 4H-SiC UV single photon counting avalanche photodiode", ELECTRONICS LET, IEE STEVENAGE, GB, vol. 41, no. 4, 17 February 2005 (2005-02-17), pages 212-214, XP006023547, ISSN: 0013-5194, DOI: 10.1049/EL:20057320
- DAVID J P R ET AL: "Nonlocal effects in thin 4H-SiC UV avalanche photodiodes", IEEE TRANSACTIONS ON ELECTRON DEVICES, IEEE SERVICE CENTER, PISACATAWAY, NJ, US, vol. 50, no. 8, 1 August 2003 (2003-08-01) , pages 1724-1732, XP011099319, ISSN: 0018-9383, DOI: 10.1109/TED.2003.815144
- YAN F ET AL: "4H-SiC avalanche photodiode with multistep junction extension termination", ELECTRONICS LET, IEE STEVENAGE, GB, vol. 37, no. 17, 16 August 2001 (2001-08-16), pages 1080-1081, XP006017057, ISSN: 0013-5194, DOI: 10.1049/EL:20010720

## Description

The present invention relates to an avalanche photodiode for detecting ultraviolet photons.

Ultraviolet radiation covers the region of the electromagnetic spectrum below the wavelength of visible light from 400 nm down to about 1 nm. This radiation is a highly ionizing radiation, which activates many chemical processes. A major natural UV source is the sun. The near-UV region (200-400 nm) is commonly divided into three subregions, in which the most common division is:
UVA; 400-320 nm
UVB; 320-280 nm
UVC; 280-200 nm

99% of the UV radiation from the sun reaching the earth surface is UVA. A small amount of UVB reaches the surface. This is the primary agent responsible for sun burn on skin, but also has the beneficial effect of inducing the production of vitamin D in skin. The UVC region is of great interest for UV detection, since radiation of this wavelength is heavily absorbed by the ozone layer, and any UVC light encountered at the earth's surface almost always comes from a man-made source. The extremely low background level in this region permits the detection of very low levels of earth-generated radiation.

The detection of UV-radiation is useful for a wide range of civil and military applications, such as chemical and biological analysis for identifying small concentrations of molecules, for instance for discovering the presence of bacteria in water. Other applications are flame detection, optical communications, process control and astronomical studies.

A high sensitivity of such a photodiode making it possible to detect very low level radiation is required for several of these applications. When radiation enters an avalanche photodiode reverse biased so as to have an active region with a high electric field for avalanche multiplication of charge carriers created therein, a chain-reaction concerning generation of electron-hole pairs will result in the diode. This avalanche multiplication of the photo current results in an amplified signal of the diode, making this type of device ideal for detecting very low radiation levels. Such an avalanche photodiode may operate in two different modes: a linear mode, in which the reverse bias is close to, but not above the breakdown voltage of the diode, and a so-called Geiger mode, in which the reverse bias is increased above the breakdown voltage of the diode but still being close thereto.

The present invention relates to such an avalanche photodiode. The invention relates to an avalanche photodiode in which the active region for avalanche multiplication of charge carriers is created in a said second layer of SiC.

J.P.R David et al in IEEE TRANSACTIONS ON ELECTRON DEVICES, Vol. 50, No. 8, 1 August 2003, pages 1724-1732 disclose a study of avalanche multiplication and excess noise characteristics of 4H-SiC avalanche photodiodes.

F. Yan et al in ELECTRONICS LETTERS, Vol. 37, No. 17, 16 August 2001, pages 1080-1081 disclose fabrication of a 4H-SiC avalanche photodiodes (APDs) with a multistep junction termination extension. The leakage current density was reduced.

GB 2 206 998 discloses an avalanche photodetector having a reduced electric field at the periphery of the PN junction and fast response time without necessarily incorporating a quaternary layer.

Avalanche photodiodes for detecting ultraviolet photons of this type are disclosed in US 6 838 741,

US 5 596 186 and US 7 291 544. A disadvantage of these ultraviolet detectors already known is that it may not be ensured that the generation of charge carriers for avalanche multiplication occurs in the bulk of the detector in said active region in order to avoid generation of charge carriers taking place at the edge of the device due to the electric field crowding normally occurring there, which would result in a very low efficiency and a nonuniform signal. To fail to guarantee that the detector signal is free from a contribution from the edge of the device, would also severely deteriorate not only the sensitivity and uniformity but also the long term stability and reproducibility of the response signal of the device to the radiation, since the edge is sensitive to surface charges. Thus, the signal of such a photodiode may especially when used for detecting low level radiation have a high content not emanating from ultraviolet photons entering said active region of the device and by that not the reliability and stability required.

### SUMMARY OF THE INVENTION

The object of the present invention is to provide an avalanche photodiode which addresses the problem discussed above of a degraded stability, sensitivity and uniformity of the response signal in such photodiodes already known as a consequence of noise.

This object is according to the invention obtained by providing an avalanche photodiode as it is defined in claim 1.

It is ensured that the avalanche multiplication occurs in the bulk of the avalanche photodiode, in said active region located under said surface by separating an edge termination of the diode and the active region thereof. Accordingly, this is achieved by extending the edge termination laterally outside the surface to be exposed to radiation. This is obtained by giving said fourth layer an effective surface charge density in a region laterally next to said surface obtaining an electric field strength substantially equal to a critical electric field strength of the diode at a pn-junction formed below said fourth layer laterally next to said surface upon application of a voltage close to a breakdown voltage of the diode across the electrodes thereof, which results in a substantially total elimination of edge influence on the signal of the diode. This approach differs from the prior art in which it is tried to reduce the influence of edge upon the detection signal by making the sensor part more efficient instead of attempting to reduce the contribution of edge effects to the detection signal.

According to an embodiment of the invention said edge termination extension is obtained by a reduction of said effective surface charge density in said fourth layer in a plurality of steps separated by a lateral distance of 1-10 µm, with the minimum number of steps being 1. This results in an efficient removal of edge influences upon the signal of the photodiode.

According to another embodiment of the invention said effective surface charge density being a product of said fourth layer electrically active doping and thickness under said second electrode is minimum 1x10<13>cm<-2>and most preferred approximately 1.3x10<13>cm<-2>.

According to another embodiment of the invention said fourth layer has a thickness being stepwisely or gradually reduced in the lateral direction away from said surface lateral border to be zero at an end of said edge termination extension where the uppermost semiconductor layer of the diode is of said first conductivity type, so that the electric field will be accurately controlled to be zero at said end.

According to another preferred embodiment of the invention the doping concentration of said fourth layer is 3x10<16>-10<19>cm<-3>next to said surface and the thickness of said fourth layer under said second electrode is 5 µm - 0.015 µm and preferably 1-2·10<18>cm<-3>and 0.15-0.075 µm, respectively. Generally the doping and thickness of said fourth layer must be selected so as to satisfy the equation q·Nsc= ε· Ec where q is electron charge, Nsc is effective surface charge, ε is dielectricity constant and Ec is critical electrical field strength for the semiconductor material.

According to another embodiment of the invention the thickness of said second layer is 0.05-0.5 µm. This thin lightly doped second layer means that the entire second layer will be depleted when the photodiode is reverse biased, so that the electric field strength therein will be constant and a well defined volume for avalanche multiplication will be formed therein. Another advantage of having such a thin second layer is that it may be totally depleted already at a low voltage, so that the photodiode will have a low breakdown voltage and by that operation voltage, well in the order of 10-20 V making it possible to use for instance conventional batteries for the operation of the diode substantially facilitating the handling of the photodiode and associated equipment.

According to another embodiment of the invention said fourth layer extends all the way over said second layer forming said third layer and a pn-junction to said second layer in the area to be exposed to the photons to be detected.

According to another embodiment of the invention the photodiode comprises a highly doped semiconductor layer of SiC and doped according to said second conductivity type located directly under said second electrode for making a good ohmic contact thereto. This results in an efficient conducting of the charge carriers to this second electrode.

According to another embodiment of the invention said first conductivity type is n and said second conductivity type is p.

According to another embodiment of the invention the thickness of said first layer is at least 2 µm, preferably 2-10 µm.

According to another embodiment of the invention the doping concentration of said first layer is at least one order of magnitude higher than the doping concentration of said second layer. This means that the second layer may easily be depleted and the electric field will be stopped to fall to substantially zero by said first layer.

According to another embodiment of the invention the doping concentration of said first layer is 5x10¹⁷- 5x10¹⁹ cm⁻³ and the doping concentration of said second layer is 1x10¹⁶- 2x10¹⁷cm⁻³. Such a low doping concentration of the second layer in combination with the reduced thickness thereof will make it possible to reach the critical electric field for avalanche within the entire second layer at a low reverse voltage, such as 10 - 20 V.

Further advantages as well as advantageous features of the invention will appear from the following description.

### BRIEF DESCRIPTION OF THE DRAWINGS

With reference to the appended drawings, below follows a specific description of embodiments of the invention and of examples.

In the drawings:
Fig 1 : is a very schematic view of an avalanche photodiode according to a first example not forming part of the invention,
Fig 2 : is a view corresponding to Fig 1 of a photodiode according to a second example.
Fig 3 : is a view corresponding to Fig 1 of the photodiode according to an embodiment of the invention,
Fig 4 : is a view corresponding to Fig 1 of photodiode according to a third example not forming part of the invention showing the arrangement of the bottom electrode in the case of an insulating substrate,
Fig 5 : is a simplified graph showing the principal of operation of a photodiode according to Fig 1 ,
Fig 6 : is a simplified view illustrating the electrical field in the device according to Fig 1 and the creation of an active avalanche multiplication region therein in operation of that photodiode,
Fig 7 : is a graph showing the reverse current I of the device according to Fig 1 versus the reverse voltage U applied across the terminals thereof, and
Fig 8 : is a view corresponding to Fig 1 of a photodiode according to a fourth example not forming part of the invention in the form of a Schottky diode.

### DETAILED DESCRIPTION OF EMBODIMENTS OF THE PRESENT INVENTION

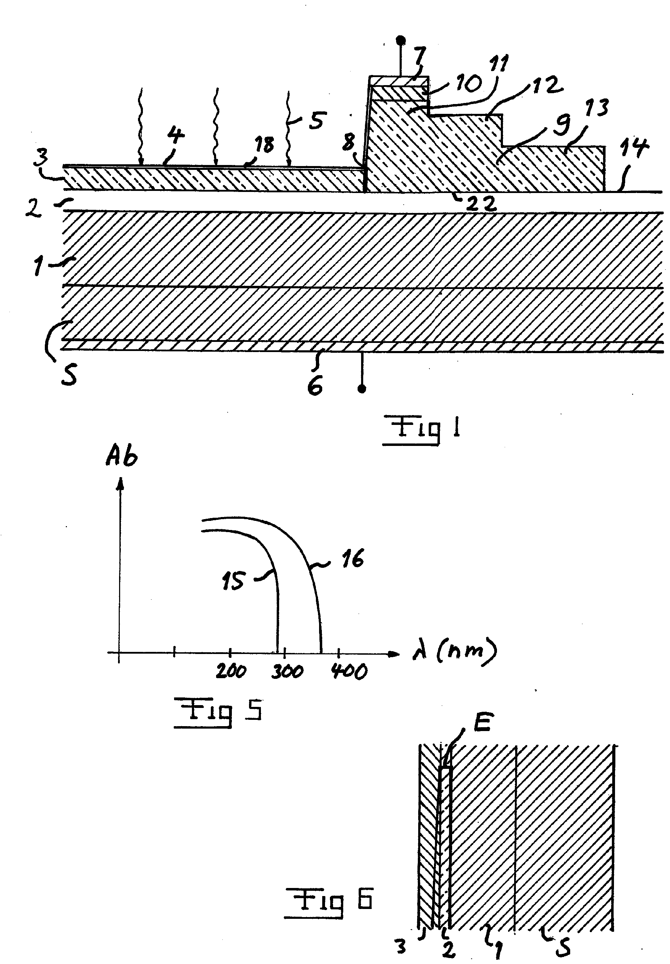

Fig 1 very schematically illustrates the design of an avalanche photodiode for detecting ultraviolet photons according an example not forming part of the invention, in which the relationship of the dimensions of the different layers are not drawn to scale, but the drawing is merely intended to explain the structure of the photodiode.

The photodiode has a first semiconductor layer 1 highly doped according to a first conductivity type, in which said first conductivity type may be n or p, and it is here n. This layer has here a thickness of 1-10 µm and a doping concentration of 5x10¹⁷- 5x10¹⁹cm⁻³. It is in the present case GaN, but it may just as well be AlₓGa₁₋ₓN, with 0 ≤ x ≤ 0.5. A second semiconductor layer 2 of GaN is arranged on top of the first layer 1. This layer is also doped according to the first conductivity type, which here is n. This second layer has a thickness of about 0.1-0.5 µm and a doping concentration of 1x10¹⁵- 5x10¹⁶cm⁻³.

A third layer 3 is located on top of the second layer and configured to form a blocking junction to the second layer in a reverse biased state of the diode, and this third layer is here doped according to a second conductivity type, which here means p, for forming a pn-junction to the second layer. This third layer may be of the same material as the first and second layer, but it has preferably a higher content of Al, so that radiation of shorter wavelengths are required for creating charge carriers therein than in the second layer. The third layer shall be kept as thin as possible in order not to lower the optical gain of the photodiode due to absorption of the photons in this layer. However, there is a trade-off between the optical gain of the photodiode and the lateral resistivity of the third layer which must be low to ensure efficient collection of the charge carriers generated in said second layer (see below). The third layer has preferably a thickness of about 0.02-0.05 µm and a doping concentration of 2x10¹⁸- 1x10¹⁹cm⁻³. The effective surface charge density N_{eff}≥1.3·10¹³cm⁻².

A surface 4 of the diode above said third layer is configured to be exposed to photons 5 to be detected.

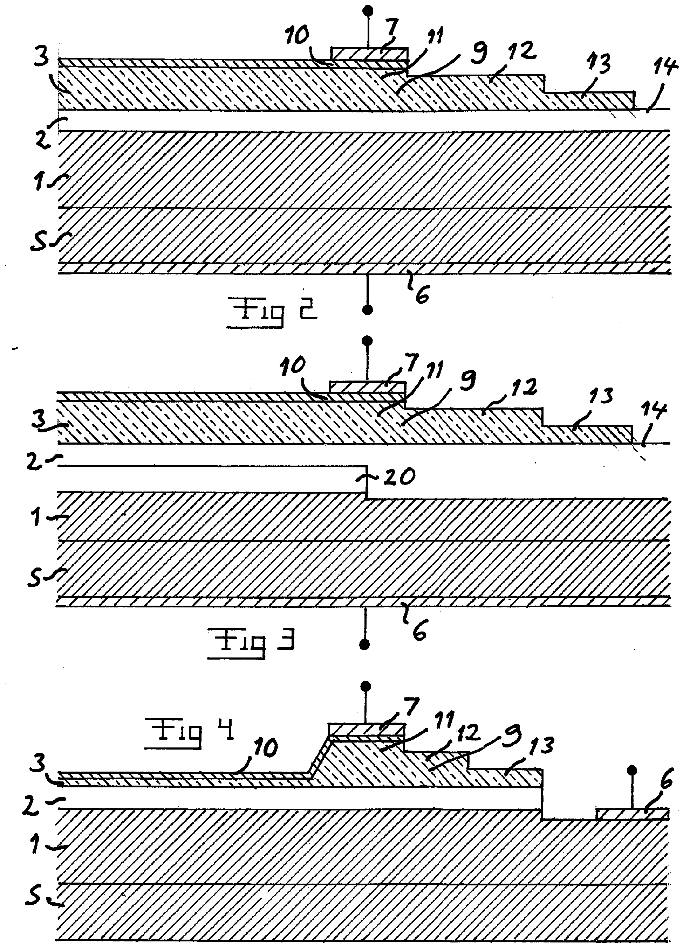

A first electrode 6 is arranged below the first layer 1, in the case of a conducting substrate S of for example SiC or GaN and is arranged in contact with said conducting substrate S or is arranged to the top of the first layer 1 in the case of an insulating substrate S of for example Al₂O₃ (as in the example shown in Fig 4), and a second electrode 7 is located above said third layer laterally to said surface 4 and next to an outer lateral border 8 defining said surface.

A fourth layer 9 of AlₓGa₁₋ₓN doped according to said second conductivity type, which here means p, is arranged on top of the second layer 2 laterally outside said surface 4 with the second electrode arranged on top thereof, with a highly doped semiconductor layer 10 of the same material and of the same conductivity type as the layer 9 located directly under the second electrode 7 for making a good ohmic contact thereto. The said fourth layer 9 may be arranged by first removing the said third layer 3 beyond the outer lateral border 8 through etching, second by growing the said fourth layer 9 on top of said second 2 and said third 3 layers and by third removing the said fourth layer 9 over the said third layer 3 and over the said surface 4 by etching. The thickness of said fourth layer 9 and the doping concentration thereof are adapted to obtain an effective surface charge density of said fourth layer in a region 11 laterally next to said surface 4 for, upon application of a voltage close to the breakdown voltage of the diode across said electrodes, obtaining an electric field strength substantially equal to a critical electric field strength of the diode at a pn-junction 22 formed below said fourth layer laterally next to said surface. This means in the present case an effective surface charge density of 1.3x10¹³cm⁻², which for said fourth layer 9 in said region 11 means a thickness of about 1.3 µm at a doping concentration of 10¹⁷cm⁻³ and about 0.13 µm at a doping concentration of 10¹⁸cm⁻³. Accordingly, it is preferred to have this layer 9 rather low doped for not requiring etching of very small steps and thus having larger tolerances during fabrication of diodes. An edge termination extension of the diode is obtained as of said lateral border 8 by a reduction of said effective surface charge density in the direction laterally away from said surface 4, which in the present case is made by stepwisely reducing the thickness of the fourth layer in subsequent regions 12, 13 and 14 in which it is zero in the region 14, i.e. etched down to the upper first conductivity type layer 2. Such a reduction of the thickness may also be combined or replaced by a reduction of the doping concentration of the fourth layer 9 in the lateral direction. The preferred effective surface charge density, in the case of two steps as in Fig 1 , is in the region 12 between 30% and 60% and in the region 13 between 15% and 40% of the effective surface charge density in the region 11. The steps in the fourth layer 9 are preferably separated by a lateral distance of 1-10 µm. The region 11 has preferably a substantially constant effective surface charge density over a certain lateral distance as of the border 8, such as at least 2 µm. The fourth layer 9 is preferably covered by an insulating passivation layer in the part not covered by second electrode 7, not shown.

It is possible to have exactly the same material for the third layer 3 and the fourth layer 9, which facilitates the production of the diode, but it is also possible to have the third layer with an Al content and the fourth layer of pure GaN, since it is easier to dope GaN.

A very thin metal layer 18, such as with a thickness below 0.05 µm, preferably 0.005-0.02 µm, for instance of Au, may be arranged on top of the third layer in said surface 4 in such a way that it extends to the second electrode 7 for conducting charge carriers thereto. The arrangement of such a metal layer will reduce said lateral resistivity so as to improve the conduction of charge carriers to the second electrode, but it will at the same time cause a reflection of a part of the photons reaching the surface 4, so it has to be made very thin and of a metal being transparent to said photons. It is then preferred to also have the third layer highly doped for obtaining a low resistance for the free charge carriers created by avalanche multiplication to reach the second electrode 7.

The diode has preferably a cellular layout which means that it is built by repetition of unit cells with different geometry. Each unit cell contains said surface 4 and the surrounding area corresponding to the region covered by the said electrode 7.

The edge termination according to Fig 1 is added only to the unit cells at the periphery of the diode. The preferred unit cell geometry may be linear-parallel, square, circular or hexagonal with the said surface 4 in the form of rectangles, squares, circles or hexagons, respectively.

Fig 2 illustrates an avalanche photodiode according to a second example, which differs from the diode shown in Fig 1 by the fact that said third layer 3 is here included in a said fourth layer 9 which covers the entire area of the diode. This reduces the number of processing steps compared to the first example, however, the example requires etching of small steps in the case when said fourth layer 9 is made out of GaN.

The thickness of said fourth layer 9 over said active area of the diode according to the second example may be made smaller compared to the thickness of said fourth layer 9 under said contact electrode 7 through etching as shown in Fig 4 .

Fig 3 illustrates an avalanche photodiode according to an embodiment of the invention differing from the example shown in Fig 2 by the fact that at least said first 1 and second 2 layers are made of SiC, here of n-type with doping concentrations of for example 5x10¹⁵cm⁻³ for both and a thickness of 1-3 µm for the first layer and approximately 0.1 µm for the second layer. Furthermore, a highly doped n-type layer 20 of SiC having a doping concentration of for example 1x10¹⁸cm⁻³ and a thickness of 0.1 µm is introduced between the first layer 1 and the second layer 2 while extending only under the active area of the device and preferably not further than to the first etched step 12 of the termination. This extra layer 20 has an effective surface charge density, i.e. a product of thickness and doping concentration, preferably being less than 1.3x10¹³cm⁻². The fourth layer 9 is of SiC having a doping concentration in the region of 10¹⁸cm⁻³. It is pointed out that the doping type can be the opposite in all layers, so that instead of having holes collected and multiplied in the n-type layers 1, 20 and 2, respectively, electrons may be collected and multiplied when making these layers of p-type instead.

Fig 4 illustrates an avalanche photodiode according to a third example not forming part of the invention, which differs from the one according to Fig 1 by the fact that the thin metal layer 18 has been replaced by an extension of the highly doped semiconductor layer 10 located under the second electrode 7 for making a good ohmic contact thereto. Furthermore, the substrate S is here made of an insulating material, such as Al₂O₃, so that the first electrode 6 is located on top of the first layer 1. The example shown in Fig 2 may of course also be modified in a similar way should a substrate S of insulating material be used in that example.

Fig 5 illustrates the absorption Ab versus the wavelength λ of photons reaching the surface 4 of the avalanche photodiode according to Fig 1. The line 15 shows the absorption of a material of AlₓGa₁₋ₓN with x=0.45 and the line 16 the absorption of GaN. Assuming that the third layer 3 is made of a material absorbing according to the line 15 and the second layer 2, in which the active region for avalanche multiplication is formed, is formed of GaN, it is ensured that, if the third layer 3 is thin enough, most of the radiation with wavelengths above 280 nm reaches said second layer, so that photons with wavelengths of 280-365 nm may be detected by this photodiode. Selecting a certain thickness of the third layer 3 may then result in a nearly completely prevention of photons with a wavelength shorter than 280 nm from reaching the second layer 2 and be detected through avalanche multiplication, so that it may be concluded that the creation of a signal means a presence of photons with wavelengths in the range of 280-365 nm.

Fig 6 illustrates how it will be possible to completely deplete said second layer 2 at a low voltage applied across the electrodes of the device thanks to a low doping concentration and a low thickness of this layer. This means that the electric field E will be nearly constant across this layer 2 and an active region of avalanche multiplication of charge carriers may be formed across the substantially entire thickness of this second layer 2. This means a well defined impact ionisation region with a nearly constant electric field resulting in a high amplification of the input (radiation) signal of the photodiode. It is possible to use a thin multiplication layer in this way, since the absorption length in GaN is extremely short (0.1-0.3 µm).

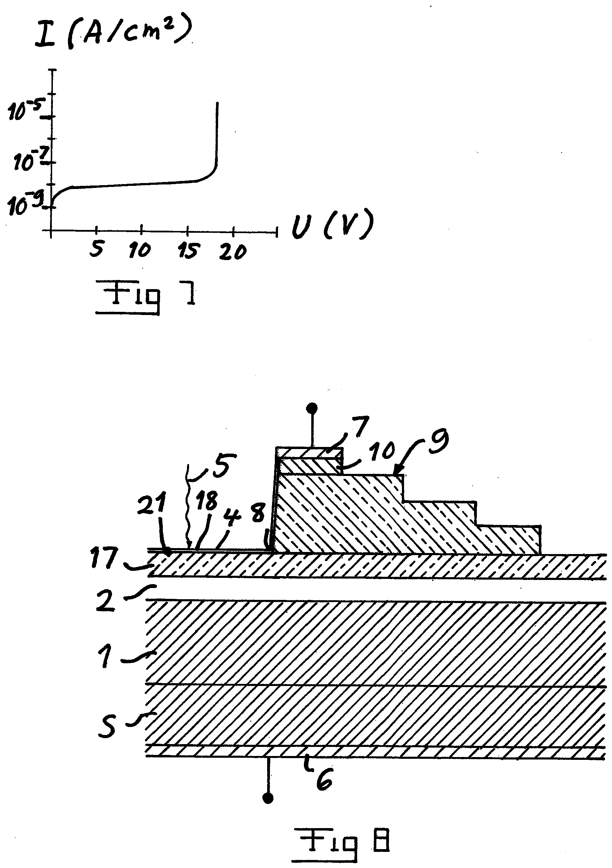

Fig 7 illustrates the reverse current I versus the voltage U applied across the electrodes of the diode according to Fig 1 , and a reverse bias with a voltage of approximately 18 V close to the breakdown voltage of the diode is selected for the operation of the diode.

Fig 8 illustrates an avalanche photodiode according to a fourth example not forming part of the invention, which differs from the diode shown in Fig 1 by the fact that said third layer is replaced by a layer 17 of a first conductivity type, here n, and the metal layer 18 is here configured to form a blocking junction to the layer 17 in the form of a Schottky junction 21 in a reverse biased state of the diode. Furthermore, it is shown that the edge termination extension may have a different number of steps than that shown in Fig 1 , and this has only to be reduced in thickness to reach the layer 17 and not to the second layer 2 as in the case of pn-junction.

Dopants suitable to be used for the semiconductor material of the photodiode of AlₓGa₁₋ₓN are Si as donor and Mg and Zn as acceptors.

The invention is of course not in any way restricted to the embodiments described above, but many possibilities to modifications thereof will be apparent to a person with ordinary skill in the art without departing from the basic idea of the invention as defined in the appended claims.

"Above" as used for the location of the different layers in the claims means that the layer in question is arranged in the vertical direction higher than the layer to which it refers, but it is not necessary that it is arranged on top of the latter layer or even over that layer, but it may be laterally displaced with respect thereto.

The photodiode may have more layers than those shown in the Figures.

"Approximately" as used for the effective surface charge density in claim 3 should be interpreted to cover the region 1.2-1.4-10¹³cm⁻².

## Claims

1. An avalanche photodiode for detecting ultraviolet photons, said photodiode comprising:
• a first semiconductor layer (1) lowly doped according to a first conductivity type, n or p,
• a second semiconductor layer (2) lowly doped according to said first conductivity type and located on top of said first layer (1),
• a third layer (3) located above said second layer (2) and configured to form a blocking junction (22) to a layer therebelow in a reverse biased state of the diode, a surface (4) of the diode above said third layer (3) being configured to be exposed to photons to be detected,
• at least said first and second layers (1, 2) are of SiC,
• a fourth layer (9) of SiC and doped according to a second conductivity type opposite to said first conductivity type is arranged above said second layer (2),
the fourth layer (9) extends all the way over said second layer forming said third layer (3) and a pn-junction to said second layer (2) in the area to be exposed to the photons to be detected,
• a first electrode (6) arranged in electrical contact with said first layer (1) and
• a second electrode (7) above the fourth layer (9), arranged laterally outside said surface (4) and next to an outer lateral border (8) defining said surface (4),
wherein an active region of a high electric field for avalanche multiplication of charge carriers by said photons in said second layer (2) is created in operation of the diode by applying a voltage close to the breakdown voltage of the diode across said electrodes (6,7), the thickness of said fourth layer (9) and the doping concentration thereof are adapted to obtain an effective surface charge density of said fourth layer (9) in a region laterally outside the surface (4) and next to the outer lateral border, so that an electric field strength substantially equal to a critical electric field strength of the diode at a pn- junction formed below said fourth layer (9) laterally outside said surface (4) and next to the outer lateral border upon application of the said voltage across said electrodes (6,7) is obtained, and an edge termination extension of the diode as of said lateral border (8) is obtained by a reduction of said effective surface charge density in the direction laterally away from said surface (4), the edge terminal extension having at least one etched step (12, 13), a highly doped layer (20) of SiC doped according to a first type of conductivity is provided between the first layer (1) and the second layer (2),
**characterized in that**
said highly doped layer (20) extends only under an active region of the device and not further than to a first etched step (12) of the edge termination extension.

2. The avalanche photodiode according to claim 1, wherein said edge termination extension is obtained by a reduction of said effective surface charge density in said fourth layer (9) in steps (11-14) separated by a lateral distance of 1-10 µm with the minimum number of steps being 1

3. The avalanche photodiode according to claim 1, wherein said effective surface charge density being a product of said fourth layer (9) electrically active doping and thickness under said second electrode is minimum 1 x10¹³cm⁻² and most preferred approximately 1.3x10¹³cm⁻².

4. The avalanche photodiode according to any of the preceding claims, wherein the doping concentration of said fourth layer (9) is 3x10¹⁶-10¹⁹cm⁻³ next to said surface (4) and that the thickness of said fourth layer (9) under said second electrode (7) is 5 µm - 0.015 µm and preferably 1-2·10¹⁸ cm⁻³ and 0.15-0.075 µm, respectively.

5. The avalanche photodiode according to any of the preceding claims, wherein the thickness of said second layer (2) is 0.05-0.5 µm.

6. The avalanche photodiode according to any of the preceding claims, comprising a highly doped semiconductor layer (10) of SiC doped according to said second conductivity type located directly under said second electrode (7) for making a good ohmic contact thereto.

7. The avalanche photodiode according to any of claims 1-6, wherein the thickness of the first layer (1) is in the interval 1-3 µm.

8. The avalanche photodiode according to any of claims 1-7, wherein the second layer (2) has a thickness of approximately 0.1 µm.

9. The avalanche photodiode according to any of claims 1-8, wherein the highly doped layer (20) has a product of thickness and doping concentration of less than 1.3x10¹³cm⁻².

10. The avalanche photodiode according to any of claims 1-9, wherein the first layer (1) and the second layer (2) have a doping concentration of 5x10¹⁵cm⁻³.

## Patentansprüche

1. Lawinenphotodiode zum Nachweis von Ultraviolettphotonen, wobei besagte Photodiode umfasst:
• eine erste Halbleiterschicht (1), die gemäß einem ersten Leitfähigkeitstyp, n oder p, niedrig dotiert ist,
• eine zweite Halbleiterschicht (2), die gemäß dem ersten Leitfähigkeitstyp niedrig dotiert ist und sich auf der Oberseite der ersten Schicht (1) befindet,
• eine dritte Schicht (3), die sich oberhalb der zweiten Schicht (2) befindet und konfiguriert ist, um eine Sperrschicht (22) zu einer Schicht zu bilden, die unterhalb in einem invers vorbelasteten Zustand der Diode liegt, eine Oberfläche (4) der Diode oberhalb der dritten Schicht (3), die konfiguriert ist, um zu detektierenden Photonen ausgesetzt zu werden,
• zumindest die erste und zweite Schicht (1, 2) bestehen aus SiC,
• eine vierte Schicht (9) aus SiC und dotiert gemäß einem zweiten Leitfähigkeitstyp entgegengesetzt zu dem ersten Leitfähigkeitstyp angeordnet oberhalb der zweiten Schicht (2),
wobei sich die vierte Schicht (9) über den gesamten Verlauf auf der zweiten Schicht erstreckt, bildend die dritte Schicht (3) und einen pn-Übergang zu der zweiten Schicht (2) in dem Bereich, der den zu detektierenden Photonen ausgesetzt sein soll,
• eine erste Elektrode (6), die in elektrischem Kontakt mit der ersten Schicht (1) angeordnet ist, und
• eine zweite Elektrode (7) über der vierten Schicht (9), die seitlich außerhalb der Oberfläche (4) und neben einem äußeren Seitenrand (8), der die Oberfläche (4) definiert, angeordnet ist,
wobei ein aktiver Bereich eines hohen elektrischen Feldes für die Lawinenvervielfachung von Ladungsträgern durch die Photonen in der zweiten Schicht (2) im Betrieb der Diode durch Anlegen einer Spannung nahe der Durchbruchspannung der Diode über die Elektroden (6,7) erzeugt wird, die Dicke der vierten Schicht (9) und die Dotierungskonzentration derselben angepasst sind, um eine effektive Oberflächenladungsdichte der vierten Schicht (9) in einem Bereich seitlich außerhalb der Oberfläche (4) und neben der äußeren seitlichen Grenze zu erhalten, so dass eine elektrische Feldstärke, die im Wesentlichen gleich einer kritischen elektrischen Feldstärke der Diode an einem pn-Übergang ist, der unterhalb der vierten Schicht (9) seitlich außerhalb der Oberfläche (4) und neben der äußeren seitlichen Grenze beim Anlegen der Spannung an die Elektroden (6, 7) erhalten wird, und eine Kantenabschlussverlängerung der Diode ab dem seitlichen Rand (8) durch eine Reduzierung der effektiven Oberflächenladungsdichte in der Richtung seitlich weg von der Oberfläche (4) erhalten wird, wobei die Kantenanschlussverlängerung mindestens einen geätzten Schritt (12, 13) hat, eine hochdotierte Schicht (20) aus SiC, die gemäß einem ersten Leitfähigkeitstyp dotiert ist, angeordnert zwischen der ersten Schicht (1) und der zweiten Schicht (2),
**dadurch gekennzeichnet, dass**
sich die hochdotierte Schicht (20) nur unter einem aktiven Bereich der Vorrichtung und nicht weiter als bis zu einem ersten geätzten Schritt (12) der Kantenabschlussverlängerung erstreckt.

2. Lawinenphotodiode nach Anspruch 1, wobei die Kantenabschlussverlängerung durch eine Reduzierung der effektiven Oberflächenladungsdichte in der vierten Schicht (9) in Schritten (11-14) erhalten wird, die durch einen seitlichen Abstand von 1-10 µm getrennt sind, wobei die Mindestanzahl der Schritte 1 ist.

3. Lawinenphotodiode nach Anspruch 1, wobei die effektive Oberflächenladungsdichte ein Produkt der vierten Schicht (9) ist, die elektrisch aktiv dotiert ist, und die Dicke unter der zweiten Elektrode mindestens 1x10¹³cm⁻² und am meisten bevorzugt etwa 1,3x10¹³cm⁻² ist.

4. Lawinenphotodiode nach einem der vorhergehenden Ansprüche, wobei die Dotierungskonzentration der vierten Schicht (9) 3x10¹⁶-10¹⁹cm⁻³ neben der Oberfläche (4) beträgt und dass die Dicke der vierten Schicht (9) unter der zweiten Elektrode (7) 5 µm - 0,015 µm und vorzugsweise 1-2•10¹⁸ cm⁻³ und 0,15-0,075 µm beträgt.

5. Lawinenphotodiode nach einem der vorhergehenden Ansprüche, wobei die Dicke der zweiten Schicht (2) 0,05-0,5 µm beträgt.

6. Lawinenphotodiode nach einem der vorhergehenden Ansprüche, umfassend eine hochdotierte Halbleiterschicht (10) aus SiC, die gemäß dem zweiten Leitfähigkeitstyp dotiert ist und sich direkt unter der zweiten Elektrode (7) befindet, um einen guten ohmschen Kontakt dazu herzustellen.

7. Lawinenphotodiode nach einem der Ansprüche 1-6, wobei die Dicke der ersten Schicht (1) im Bereich von 1-3 µm liegt.

8. Lawinenphotodiode nach einem der Ansprüche 1-7, wobei die zweite Schicht (2) eine Dicke von etwa 0,1 µm aufweist.

9. Lawinenphotodiode nach einem der Ansprüche 1-8, wobei die hochdotierte Schicht (20) ein Produkt mit einer Dicke und Dotierungskonzentration von weniger als 1,3x10¹³cm⁻² aufweist.

10. Lawinenphotodiode nach einem der Ansprüche 1-9, wobei die erste Schicht (1) und die zweite Schicht (2) eine Dotierungskonzentration von 5x10¹⁵cm⁻³ aufweisen.

## Revendications

1. Photodiode à avalanche pour détecter des photons d'ultraviolets, ladite photodiode comprenant :
- une première couche de semi-conducteurs (1) faiblement dopée selon un premier type de conductivité, n ou p,
- une deuxième couche de semi-conducteurs (2) faiblement dopée selon ledit premier type de conductivité et située par-dessus ladite première couche (1),
- une troisième couche (3) située au-dessus de ladite deuxième couche (2) et configurée pour former une jonction de blocage (22) avec une couche sous celle-ci dans un état de polarisation inversée de la diode, une surface (4) de la diode au-dessus de ladite troisième couche (3) étant configurée pour être exposée à des photons à détecter,
- au moins lesdites première et deuxième couches (1, 2) sont en SiC,
- une quatrième couche (9) en SiC et dopée selon un second type de conductivité opposé audit premier type de conductivité est agencée au-dessus de ladite deuxième couche (2),
la quatrième couche (9) s'étend tout du long au-dessus de ladite deuxième couche formant ladite troisième couche (3) et une jonction pn avec ladite deuxième couche (2) dans la zone à exposer aux photons à détecter,
- une première électrode (6) agencée en contact électrique avec ladite première couche (1) et
- une seconde électrode (7) au-dessus de la quatrième couche (9), agencée latéralement à l'extérieur de ladite surface (4) et près d'une limite latérale externe (8) définissant ladite surface (4),
dans laquelle une région active d'un champ électrique intense pour une multiplication en avalanche de porteurs de charge par lesdits photons dans ladite deuxième couche (2) est créée lors du fonctionnement de la diode en appliquant une tension proche de la tension de claquage de la diode à travers lesdites électrodes (6, 7), l'épaisseur de ladite quatrième couche (9) et la concentration de dopage de celle-ci sont adaptées pour obtenir une densité de charge de surface effective de ladite quatrième couche (9) dans une région latéralement à l'extérieur de la surface (4) et près de la limite latérale externe, de sorte qu'une intensité de champ électrique sensiblement égale à une intensité de champ électrique crique de la diode au niveau d'une jonction pn formée sous ladite quatrième couche (9) latéralement à l'extérieur de ladite surface (4) et près de la limite latérale externe au moment de l'application de ladite tension à travers lesdites électrodes (6, 7) est obtenue, et une extension de raccordement de bord de la diode comme de ladite limite latérale (8) est obtenue par une réduction de ladite densité de charge de surface effective dans la direction s'éloignant latéralement de ladite surface (4), l'extension de borne de bord ayant au moins un palier gravé (12, 13), une couche fortement dopée (20) de SiC dopée selon un premier type de conductivité est fournie entre la première couche (1) et la deuxième couche (2),
**caractérisée en ce que**
ladite couche fortement dopée (20) s'étend uniquement sous une région active du dispositif et pas plus loin qu'un premier palier gravé (12) de l'extension de raccordement de bord.

2. Photodiode à avalanche selon la revendication 1, dans laquelle ladite extension de raccordement de bord est obtenue par une réduction de ladite densité de charge de surface effective dans ladite quatrième couche (9) dans des paliers (11-14) séparés par une distance latérale de 1 à 10 µm avec le nombre minimum de paliers qui est de 1.

3. Photodiode à avalanche selon la revendication 1, dans laquelle ladite densité de charge de surface effective est un produit d'un dopage électriquement actif de ladite quatrième couche (9) et l'épaisseur sous ladite seconde électrode est de 1 x 10¹³ cm⁻² minimum et de manière préférée entre toutes de 1,3 x 10¹³ cm⁻².

4. Photodiode à avalanche selon l'une quelconque des revendications précédentes, dans laquelle la concentration de dopage de ladite quatrième couche (9) est de 3 x 10¹⁶ - 10¹⁹ cm⁻³ près de ladite surface (4) et l'épaisseur de ladite quatrième couche (9) sous ladite seconde électrode (7) est de 5 µm à 0,015 µm et de préférence de 1 à 2 · 10¹⁸ cm⁻³ et de 0,15 à 0,075 µm, respectivement.

5. Photodiode à avalanche selon l'une quelconque des revendications précédentes, dans laquelle l'épaisseur de ladite seconde couche (2) est de 0,05 à 0,5 µm.

6. Photodiode à avalanche selon l'une quelconque des revendications précédentes, comprenant une couche de semi-conducteurs fortement dopée (10) en SiC dopée selon ledit second type de conductivité située directement sous ladite seconde électrode (7) pour établir un bon contact ohmique avec celle-ci.

7. Photodiode à avalanche selon l'une quelconque des revendications 1 à 6, dans laquelle l'épaisseur de la première couche (1) est dans l'intervalle de 1 à 3 µm.

8. Photodiode à avalanche selon l'une quelconque des revendications 1 à 7, dans laquelle la deuxième couche (2) a une épaisseur d'approximativement 0,1 µm.

9. Photodiode à avalanche selon l'une quelconque des revendications 1 à 8, dans laquelle la couche fortement dopée (20) a un produit de l'épaisseur et de la concentration de dopage inférieur à 1,3 x 10¹³ cm⁻².

10. Photodiode à avalanche selon l'une quelconque des revendications 1 à 9, dans laquelle la première couche (1) et la deuxième couche (2) ont une concentration de dopage de 5 x 10¹⁵ cm⁻³.
